Europäisches Patentamt

European Patent Office

Office européen des brevets

(19)

(11) **EP 0 624 959 B1**

(12) **FASCICULE DE BREVET EUROPEEN**

(45) Date de publication et mention
de la délivrance du brevet:
**11.08.1999 Bulletin 1999/32**

(51) Int Cl.⁶: **H04B 1/28**, H04B 1/30,
H03D 3/00

(21) Numéro de dépôt: **94106952.8**

(22) Date de dépôt: **04.05.1994**

(54) **Récepteur radio FM comprenant un circuit de suréchantillonnage**

FM-Empfänger mit einer Schaltung zur Überabtastung

FM receiver with an oversampling circuit

(84) Etats contractants désignés:
**AT BE CH DE DK ES FR GB GR IE IT LI LU MC NL
PT SE**

(30) Priorité: **12.05.1993 FR 9305813**

(43) Date de publication de la demande:
**17.11.1994 Bulletin 1994/46**

(73) Titulaire: **C.S.E.M. CENTRE SUISSE
D'ELECTRONIQUE ET DE MICROTECHNIQUE
SA
2007 Neuchâtel (CH)**

(72) Inventeur: **Pardoen, Matthijs D.
CH-2074 Marin (CH)**

(74) Mandataire: **de Montmollin, Henri et al
ICB
Ingénieurs Conseils en Brevets SA
Rue des Sors 7
2074 Marin (CH)**

(56) Documents cités:
**WO-A-93/02507**

- **ELECTRONICS & WIRELESS WORLD, vol.96,
no.11, Novembre 1990, SUTTON,GB pages 962 -
967, XP171859 HICKMAN 'Direct-conversion FM
design'**
- **ELECTRONIC COMPONENTS & APPLICATIONS,
vol.5, no.3, Juin 1983, EINDHOVEN,NL pages 159
- 170 DOOREMOLEN ET AL 'A complete f.m.
radio on a chip'**

## Description

La présente invention concerne, d'une façon générale, des récepteurs radio, destinés à recevoir un signal de message modulé en fréquence (FM), et, plus particulièrement, des récepteurs radio de ce type comprenant un oscillateur local, un étage hétérodyne destiné à mélanger le signal de message modulé reçu avec le signal engendré par l'oscillateur local, pour abaisser la fréquence modulée par le signal de message jusqu'à une fréquence intermédiaire, et un étage démodulateur destiné à recevoir de l'étage hétérodyne un signal de sortie dont il est chargé d'extraire le signal de message. Le récepteur FM est conçu pour être réalisé sous la forme d'un circuit intégré unique et dans la suite du présent mémoire, la présente invention sera explicitée dans le cadre de cet exemple de réalisation. Toutefois, il est évident que l'invention n'est pas limitée à cette réalisation particulière.

A l'heure actuelle, on utilise très largement la modulation de fréquence pour assurer la transmission de signaux de message, en raison principalement de sa capacité de supprimer le bruit. La modulation de fréquence consiste en la modulation en fréquence d'un signal porteur par un signal de message, étant entendu que l'amplitude du signal reste toujours constante. Par conséquent, l'information contenue dans un signal FM est représentée par les passages par zéro du signal modulé que le récepteur doit détecter. En Europe, la radio-diffusion en stéréophonie utilise la bande de fréquences allant de 88 à 108 MHz.

La plupart du temps, les récepteurs FM sont du type hétérodyne, dans lequel les signaux reçus par le récepteur sont mélangés avec un signal engendré par un oscillateur local de manière à abaisser la fréquence du signal reçu et ainsi permettre un meilleur filtrage du signal.

La fréquence de l'oscillateur local peut être régulée par rapport à la fréquence porteuse de manière que les différentes fréquences radio des émetteurs puissent être converties en la fréquence intermédiaire qui, elle, est fixe. Le signal de fréquence intermédiaire modulé peut alors être détecté par un circuit de démodulation approprié.

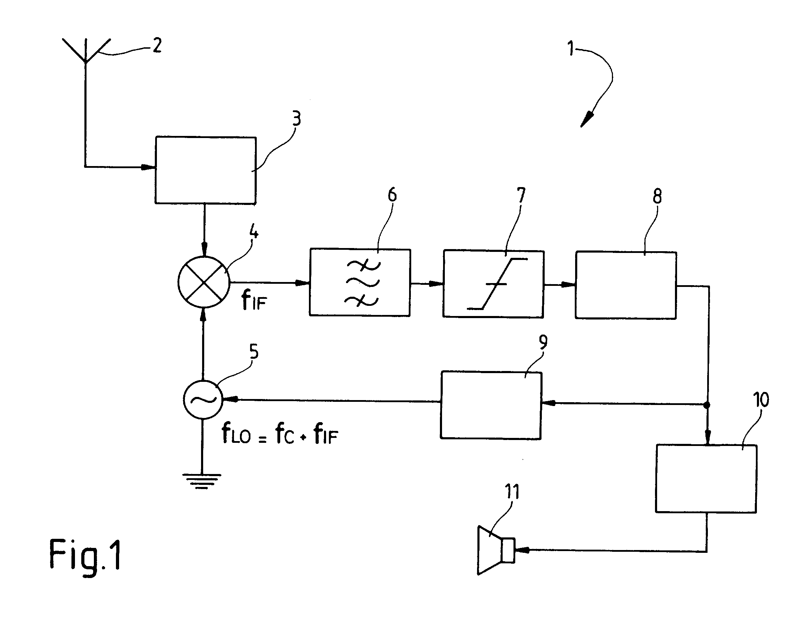

La figure 1 des dessins annexés montre un exemple d'un tel récepteur FM 1 du type superhétérodyne et à abaissement de fréquence, ce récepteur comprenant essentiellement une antenne 2, un étage 3 à haute fréquence (RF), un mélangeur 4, un oscillateur local 5, un filtre 6 à fréquence intermédiaire (IF), un amplificateur/limiteur 7, un démodulateur 8, un étage 9 de commande automatique de fréquence (AFC), un amplificateur audio 10 et un haut-parleur 11. L'antenne 2 capte des signaux situés dans la bande FM de transmission de 88 à 108 MHz et passe les signaux électriques correspondants à l'étage 3 à haute fréquence.

L'étage à haute fréquence 3 est accordé sur la fréquence porteuse $f_c$ d'un émetteur choisi et amplifie les signaux électriques reçus de l'antenne 2 dans une bande de fréquences centrée sur la fréquence $f_c$, tout en rejetant les fréquences-images parasites. Le signal de l'oscillateur local 5 et le signal provenant de l'étage à haute fréquence 3 sont multipliés par le mélangeur 4 de manière que le signal de message apparaissant à la sortie du mélangeur 4 soit modulé à la fréquence intermédiaire $f_{IF}$.

L'accord de l'oscillateur local 5 et celui de l'étage RF 3 sont couplés afin d'améliorer le rejet des fréquences-images dans le récepteur FM 1. Les caractéristiques de fonctionnement du filtre IF 6 sont choisies de telle manière que seuls les signaux situés dans une bande de fréquences centrée autour de la fréquence intermédiaire $f_{IF}$ passent à travers le filtre.

L'amplificateur/limiteur 7 limite l'amplitude du signal que laisse passer le filtre 6 pour en éliminer toute composante en modulation d'amplitude AM.

Le démodulateur FM 8 démodule le signal issu de l'amplificateur/limiteur 7 et fait passer les signaux de message ainsi élaborés vers l'amplificateur audio 10. Les signaux sont alors transmis de la sortie de cet amplificateur audio 10 vers le haut-parleur 11 afin d'y être restitués. Enfin, l'étage AFC 9 permet d'opérer l'accord fin de la fréquence $f_{LO}$ du signal de l'oscillateur local 5 en fonction de la sortie continue du démodulateur 8 et ceci afin de maintenir constante la fréquence intermédiaire $f_{IF}$.

Souvent, dans les récepteurs FM, on choisit la fréquence intermédiaire à environ 10,7 MHz, fréquence qui est légèrement supérieure à la moitié de la bande de diffusion FM de 20 MHz de manière que toutes les fréquences-images soient situées en dehors de cette bande de diffusion. Les récepteurs FM de type superhétérodyne fonctionnant avec de telles fréquences intermédiaires élevées peuvent être quasiment totalement intégrés sur une seule puce de circuit intégré, cependant que le traitement des signaux qu'impliquent de tels récepteurs, nécessite l'utilisation de circuits d'accord LC situés en dehors de la puce et des filtres en céramique ou à ondes acoustiques superficielles dans les étages RF, hétérodyne et de démodulation du récepteur.

L'emploi de fréquences intermédiaires plus basses sur lesquelles on peut accorder au moyen de filtres à faible facteur Q totalement intégrés, supprime cette nécessité de ces filtres situés en dehors de la puce du récepteur, ce qui permet donc de réaliser celui-ci sur une seule puce à laquelle n'est associé qu'un nombre de composants externes aussi faible que possible.

Par conséquent, dans certains récepteurs FM, on utilise une fréquence intermédiaire $f_{IF}$ de seulement 70 kHz, ce qui permet de les réaliser pratiquement totalement sous forme d'une seule puce de circuit intégré. Cette valeur de la fréquence intermédiaire est choisie de telle manière que la fréquence-image de l'émetteur choisi se situe à peu près à mi-chemin entre la fréquence centrale de cet émetteur et celle de l'émetteur adjacent.

Cependant, ces récepteurs FM ont l'inconvénient de posséder une largeur de bande étroite. Le repliement de spectre (terme anglo-saxon : "aliasing") entraîne une distorsion considérable lorsque la fréquence de modulation, c'est-à-dire la fréquence du signal de message est supérieure à la fréquence intermédiaire $f_{IF}$. Par ailleurs, la dérive des multiplicateurs et des détecteurs de flancs utilisés dans les démodulateurs provoque une distorsion importante par repliement de spectre, si la fréquence de modulation est supérieure à la moitié de la fréquence intermédiaire. Ainsi, la réduction de la fréquence intermédiaire $f_{IF}$ à 70 kHz a pour effet une réduction correspondante de la largeur de bande du signal de message qui peut être reçu et démodulé par le récepteur FM.

La distorsion par repliement de spectre pose un problème surtout dans des systèmes de transmission utilisant le multiplexage par division de fréquence. La radiodiffusion en FM en vigueur en Europe est un exemple typique d'un tel système car, dans ce cas, de l'information principale en stéréophonie est modulée sur une sous-porteuse de 38 kHz et de l'information numérique accessoire, complémentaire au programme principal (appelée aussi "système RDS" pour "Radio Data System"), est présentée sous forme de signaux à faible amplitude et modulée sur une sous-porteuse de 57 kHz par décalage de phase (modulation PSK). Pour restituer cette information numérique accessoire à faible amplitude, la largeur de bande de sortie du démodulateur FM devrait être d'au moins 60 kHz.

On comprend donc que l'utilisation d'une fréquence intermédiaire de l'ordre de 70 kHz peut provoquer un mélange par repliement de spectre des signaux audio en monophonie à 13 kHz et à forte amplitude et des signaux RDS à faible amplitude.

La fréquence intermédiaire maximale utilisable est imposée par le rejet souhaité de la fréquence-image et par l'espacement des canaux ou émetteurs dans la bande de diffusion FM. Par conséquent, la largeur de bande audio des signaux démodulés ne peut donc être améliorée simplement par une augmentation de la fréquence intermédiaire $f_{IF}$ du récepteur.

L'invention a pour but de fournir un récepteur radio destiné à recevoir un signal de message modulé en fréquence qui permet de remédier aux inconvénients de la technique antérieure.

L'invention a donc pour objet un récepteur radio destiné à recevoir un signal FM choisi dans lequel un signal de message A(t) module la fréquence d'une porteuse, ce récepteur comprenant un oscillateur local qui engendre un signal local d'oscillation, un étage hétérodyne pour mélanger le signal FM choisi avec le signal engendré par l'oscillateur local, afin d'abaisser la fréquence de la porteuse modulée par le signal de message jusqu'à une fréquence intermédiaire et un étage démodulateur connecté à la sortie de l'étage hétérodyne pour en recevoir un signal et en extraire ledit signal de message, caractérisé en ce que ledit étage hétérodyne comprend un circuit générateur de signaux destiné à produire n signaux $a_1....a_n$, chacun de ses signaux ayant ladite fréquence intermédiaire modulée par ledit signal de message, lesdits signaux étant liés les uns aux autres par l'expression :

$$a_i = \cos \left[ \omega_{IF} t + k_f \int^t A(t).dt + \Omega + \pi.\left(^i/_n\right) \right]$$

dans laquelle $\omega_{IF}$, $k_f$ et $\Omega$ sont des constantes, n est un nombre entier positif supérieur ou égal à 2 et i est une valeur égale à un nombre entier quelconque inférieur ou égal à n, ledit étage hétérodyne comprenant en outre un circuit multiplicateur destiné à multiplier entre eux lesdits n signaux afin d'engendrer à sa sortie un signal dans lequel ledit signal de message est modulé à une fréquence égale à n fois ladite fréquence intermédiaire.

Comme la fréquence du signal à fréquence intermédiaire modulée est multipliée par un facteur n, la largeur de bande démodulée du signal de message est augmentée également par un facteur n, sans qu'il soit nécessaire de modifier la fréquence intermédiaire utilisée dans le récepteur FM.

D'autres caractéristiques et avantages de l'invention apparaîtront au cours de la description qui va suivre, donnée uniquement à titre d'exemple et faite en se référant aux dessins annexés sur lesquels:

- la figure 1 déjà décrite, est un schéma d'un récepteur FM selon la technique antérieure;
- la figure 2 est un schéma d'un premier mode de réalisation d'un récepteur FM selon l'invention;

la figure 3 est un schéma d'un second mode de réalisation du récepteur FM selon l'invention; et

la figure 4 représente le schéma d'une variante de l'étage hétérodyne utilisé dans le récepteur FM suivant l'invention.

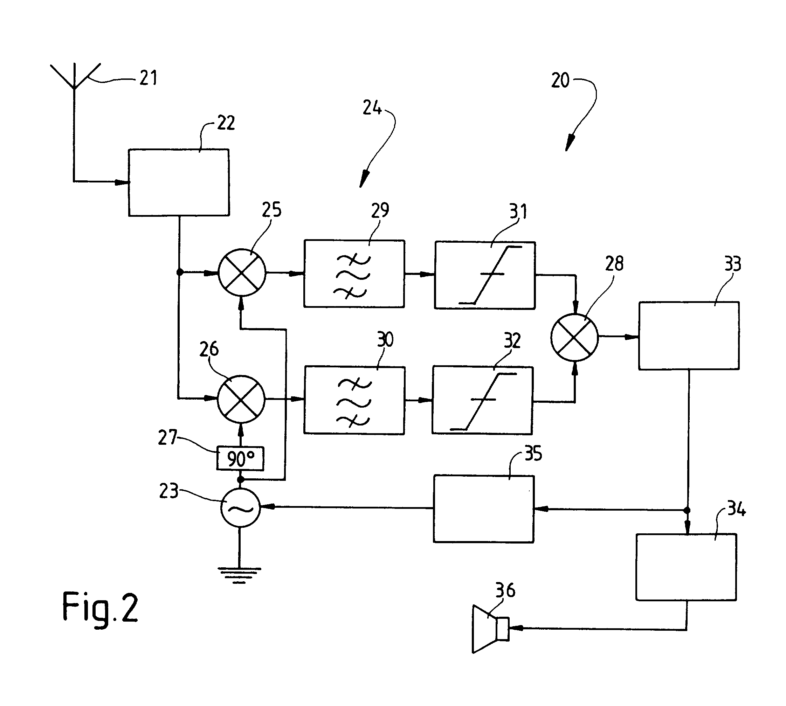

En se référant à la figure 2, on a représenté un récepteur radio 20 destiné à recevoir un signal de message modulé en fréquence. Il comprend une antenne 21, un étage haute fréquence (RF) 22, un oscillateur local 23 et un étage hétérodyne 24. Ce dernier comprend deux mélangeurs 25 et 26, un déphaseur 27 et un mélangeur basse fréquence 28. L'antenne 21 et l'étage RF 22 fonctionnent de la même façon que l'antenne 2 et l'étage RF 3 du récepteur 1, des signaux FM reçus par l'antenne 21 étant appliqués à l'étage RF 22 qui ne laisse passer que les signaux de message modulés en fréquence qui se situent dans la largeur de bande centrée sur la fréquence porteuse $f_c$ choisie. Comme décrit précédemment, l'oscillateur local 23 fournit un signal d'oscillation local $f_{LO}$ réglé à une valeur égale à la fréquence porteuse $f_c$ plus ou moins la fréquence intermédiaire $f_{IF}$ désirée du récepteur 1.

Le signal de sortie de l'oscillateur local 23 est appliqué au déphaseur 27 qui en décale la phase de 90°. Ce signal déphasé et le signal d'oscillation local initial sont ainsi à la même fréquence $f_{LO}$, tout en étant en quadrature de phase.

Le signal d'oscillation local initial et le signal provenant de l'étage RF 22, sont multipliés dans le mélangeur 25 pour abaisser la fréquence intermédiaire modulée du récepteur 20. Le signal provenant du déphaseur 27 est multiplié par le signal provenant de l'étage RF 22 par le mélangeur 26 de sorte qu'à la sortie de ce dernier le signal de message choisi module également un signal ayant la fréquence intermédiaire $f_{IF}$. Cependant, le signal modulé par le signal de message à la sortie du mélangeur 26 est en quadrature avec le signal modulé par le signal de message apparaissant à la sortie du mélangeur 25.

Les signaux apparaissant aux sorties des deux mélangeurs 23 et 24 sont donc respectivement de la forme :

$$I(t) = \cos [\omega_{IF}t + k_f \int^t A(t)^*dt + \Omega] \qquad (1),$$

et

$$Q(t) = \cos [\omega_{IF}t + k_f \int^t A(t)^*dt + \Omega + {}^{\pi}/_2] \qquad (2)$$

dans lesquelles A(t) est le signal de message choisi.

L'étage de fréquence intermédiaire 24 comprend également des filtres passe-bande 29 et 30 qui sont tous deux accordés sur la fréquence $f_{IF}$, et également des amplificateurs/limiteurs 31 et 32. Le signal I(t) passe à travers le filtre passe-bande 29 et toute composante en modulation d'amplitude (AM) en est éliminée par l'amplificateur/limiteur 31. De même, le signal Q(t) passe à travers le filtre passe-bande 30 et toute composante AM en est éliminée par l'amplificateur/limiteur 32.

D'après les équations (1) et (2) ci-dessus, on peut constater que les passages par zéro des signaux I(t) et Q(t) interviennent à des instants différents. Lorsque $k_f \int^t A(t).dt \ll {}^{\pi}/_2$, et pour $\Omega = 0$, ces instants de passages par zéro sont donnés respectivement par les équations suivantes :

$$t_{I=O} \approx {}^{n}/(2^*f_{IF}) \qquad \text{et} \qquad t_{Q=0} \approx (n + {}^{1}/_2)/(2^*f_{IF})$$

dans lesquelles n est un nombre entier positif. Cela veut dire que les passages par zéro du signal Q(t) se produisent exactement au milieu des passages par zéro du signal I(t).

Comme décrit précédemment, la largeur de bande audio des récepteurs FM du type représenté à la figure 1 est limitée par leur fréquence intermédiaire. Dans ces récepteurs de l'art antérieur, un repliement de spectre se produit, lorsque la fréquence du signal de message A(t) dépasse la moitié de la fréquence intermédiaire $f_{IF}$. Cette limitation peut également être décrite en faisant référence à un processus d'échantillonnage analogique dans lequel les instants d'échantillonnage du signal de message A(t) sont déterminés par les passages par zéro du signal à fréquence intermédiaire analogique modulé en fréquence. Cependant, à la différence des processus d'échantillonnage normaux, l'information à extraire des signaux modulés en fréquence n'est pas contenue dans les valeurs instantanées de la forme d'onde échantillonnée, mais dans les instants auxquels les échantillons sont pris.

En revenant maintenant à la figure 2, on peut voir que pour chacun des signaux I(t) et Q(t), le signal de message A(t) est échantillonné au rythme de la fréquence $f_{IF}$. Toutefois, dans le signal I(t), les instants auxquels le signal de message A(t) est échantillonné, se situent exactement à mi-chemin entre ceux auxquels est échantillonné le signal Q(t).

Le mélangeur 28 combine les signaux I(t) et Q(t) de manière à produire sur sa sortie une version suréchantillonnée du signal issu du mélangeur 25. Le signal de message A(t) est donc réellement échantillonné deux fois plus vite que la fréquence intermédiaire $f_{IF}$ de sorte que la fréquence du signal de message A(t) à laquelle le repliement de spectre risque de se produire, ou, en d'autres termes, la largeur de bande du signal de message démodulé, sont doublées. Le récepteur FM selon l'invention est ainsi capable de travailler avec une fréquence intermédiaire de 70 kHz tout en pouvant démoduler les signaux RDS inclus dans les programmes radiodiffusés en FM, qui sont modulés sur une sous-porteuse de 57 kHz.

Un repliement de spectre ne peut donc se produire que si le signal de message A(t) a une fréquence supérieure à la fréquence intermédiaire elle-même, ce qui est le double de la limite de distorsion à 35 kHz des récepteurs FM de l'art antérieur.

Le récepteur FM 20 comprend en outre un démodulateur FM 33, un amplificateur/décodeur audio 34, un étage 35 de commande automatique de fréquence et un haut-parleur 36. Le démodulateur FM 33 démodule le signal provenant du mélangeur 28 et il peut être du type travaillant avec la détection de pente, la détection de quadrature, une boucle verrouillée en phase ou en fréquence ou toute autre technique appropriée de démodulation FM.

Le signal provenant du démodulateur 33 est amplifié par l'amplificateur/décodeur 34, puis passe au haut-parleur 36. La figure 2 montre un simple récepteur FM mono, mais il est clair que la présente invention s'applique également à des récepteurs FM stéréo dans lesquels l'amplificateur/décodeur, les haut-parleurs et les filtres associés sont adaptés pour traiter et restituer un signal stéréo. On comprend également que dans d'autres variantes de l'invention, les signaux issus du démodulateur 33 peuvent ne pas être transmis à un haut-parleur afin d'y être restitués de façon audible. Par exemple, les signaux issus du démodulateur 33 peuvent être des signaux multiplexés par division de fréquence pour des applications en télémétrie ou d'autres applications dans lesquelles on a besoin de la transmission de signaux de message.

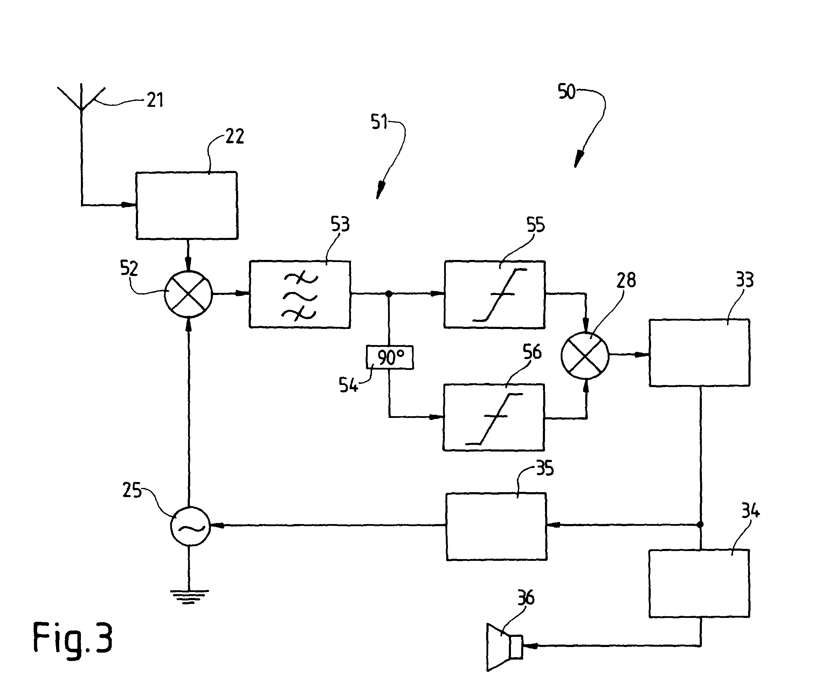

Dans un autre mode de réalisation de la présente invention (figure 3), un récepteur 50 comprend une antenne 21, un étage RF 22, un oscillateur local 25, un mélangeur 28, un démodulateur FM 33, un amplificateur décodeur 34, un étage AFC 35 et un haut-parleur 36. Les fonctions et le fonctionnement de ces composants sont identiques à ceux décrits précédemment.

Le récepteur Fm 50 comprend en outre un étage hétérodyne 51 comprenant un mélangeur 52 et un filtre passe-bande 53, un déphaseur 54 et des amplificateurs/limiteurs 55 et 56. Dans ce mode de réalisation, le mélangeur 52 multiplie entre eux les signaux provenant de l'oscillateur local 25 et de l'étage RF 22 pour abaisser la fréquence du signal qui est modulé par le signal de message, jusqu'à la fréquence intermédiaire $f_{IF}$. Ce signal IF est passé à travers le filtre passe-bande 53 et l'amplificateur/limiteur 55, puis appliqué à l'une des entrées du mélangeur 28. Le déphaseur 54 reçoit également le signal IF du filtre passe-bande 53 et lui impose un déphasage de 90°. La sortie du déphaseur 54 passe à travers l'amplificateur/limiteur 56 avant d'être appliquée à l'autre entrée du mélangeur 28.

Comme précédemment, les signaux appliqués aux deux entrées du mélangeur 28 contiennent le signal de message modulé à la fréquence intermédiaire $f_{IF}$, tout en étant en quadrature de phase l'un par rapport à l'autre. Par conséquent, le signal de message est échantillonné à la sortie du mélangeur 28, à une fréquence qui est le double de la fréquence intermédiaire, ce qui double la largeur de bande qu'avait le signal de message démodulé précédemment. Ainsi, le récepteur 50 peut démoduler des signaux de message dont la fréquence peut être aussi élevée que la fréquence intermédiaire $f_{IF}$, sans que cette fréquence intermédiaire elle-même ait à être augmentée.

Dans les deux modes de réalisation que l'on vient de décrire, on crée donc deux signaux en quadrature qui sont modulés à la fréquence intermédiaire du récepteur et qui sont ensuite combinés de sorte que le signal de message est échantillonné au double de la fréquence intermédiaire. L'utilisation de l'un ou l'autre des modes de réalisation dépendra de l'application particulière que l'on envisagera. Par exemple, dans une application dans laquelle une faible consommation d'énergie n'est pas une contrainte importante, on utilisera de préférence le récepteur FM 20 de la figure 2 qui comprend un mélangeur supplémentaire à la suite de l'étage RF, ce qui augmente la consommation d'énergie du récepteur. En revanche, si on doit réaliser un récepteur à faible consommation d'énergie, on utilisera de préférence un récepteur selon la figure 3 avec un déphaseur 54 qui doit travailler à des fréquences plus faibles que le déphaseur 26 de la figure 2, mais qui est plus difficile à réaliser.

Dans encore un autre mode de réalisation, le déphaseur 27 peut être éliminé, un déphaseur RF pouvant être connecté à l'étage 22 pour décaler de $\pi/2$ radians la phase du signal de sortie de l'étage RF appliqué à l'un des mélangeurs 25 ou 26. Lorsque les signaux reçus par les mélangeurs 25 et 26 sont multipliés par le signal local d'oscillation, deux signaux en quadrature sont produits à leurs sorties.

Les figures 2 et 3 ainsi que le mode de réalisation décrit dans le paragraphe qui précède, constituent des exemples spécifiques d'un principe plus général qui peut être mis en oeuvre selon l'invention pour augmenter la largeur de bande du signal de message démodulé dans les récepteurs FM. Les modes de réalisation décrits ci-dessus n'utilisent que deux signaux déphasés de 90°, mais on peut également engendrer dans le récepteur FM n signaux $a_1....a_n$ déphasés de $\pi/n$ l'un par rapport à l'autre, n étant un nombre entier positif supérieur ou égal à 2, ces signaux ayant entre eux la relation suivante :

$$a_i(t) = \cos\left[\omega_{IF}t + k_f \int^t A(t)^* dt + \Omega + \pi^*\left(^i/_n\right)\right]$$

dans laquelle $\omega_{IF}$, $k_f$ et $\Omega$ sont des constantes et i prend toute valeur entière inférieure ou égale à n.

En substituant ( $\omega_{IF}t + k_f \int^t A(t)^* dt + \Omega$) par $\phi$ dans cette expression, on a :

$$a_1 = \cos\left[\phi + ^\pi/_2\right] \text{ et } a_2 = \cos\left[\phi + \pi\right],$$

pour n = 2,

$$a_1 = \cos\left[\phi + ^\pi/_3\right], \ a_2 = \cos\left[\phi + ^{2\pi}/_3\right]$$

et

$$a_3 = \cos\left[\phi + \pi\right],$$

pour n = 3,

$$a_1 = \cos\left[\phi + ^\pi/_4\right], \ a_2 = \cos\left[\phi + ^\pi/_2\right],$$

$$a_3 = \cos\left[\phi + ^{3\pi}/_4\right] \text{ et } a_4 = \cos\left[\phi + \pi\right],$$

pour n = 4,
etc.

Chaque signal est traité dans un amplificateur/limiteur pour éliminer toute modulation d'amplitude, après quoi tous les signaux limités $a_1$ à $a_n$ sont multipliés entre eux pour engendrer un signal analogique IF suréchantillonné du signal de message. Donc, pour deux signaux $a_1$ et $a_2$, le signal de message est échantillonné à une fréquence double de la fréquence intermédiaire, les signaux échantillonnant l'un après l'autre le signal de message avec un décalage de phase de $\pi/2$ radians. Avec trois signaux a1, a2 et a3, le signal de message est échantillonné à une fréquence qui est trois fois la fréquence intermédiaire, les signaux échantillonnant l'un après l'autre le signal de message avec un décalage de phase de $\pi/3$ radians, ainsi de suite.

La largeur de bande du signal de message démodulé est alors augmentée, respectivement d'un facteur deux, trois, quatre etc.

Bien entendu, le démodulateur FM et les autres composants du récepteur FM doivent naturellement être adaptés dans chaque cas, pour traiter la fréquence d'échantillonnage accrue du signal de message.

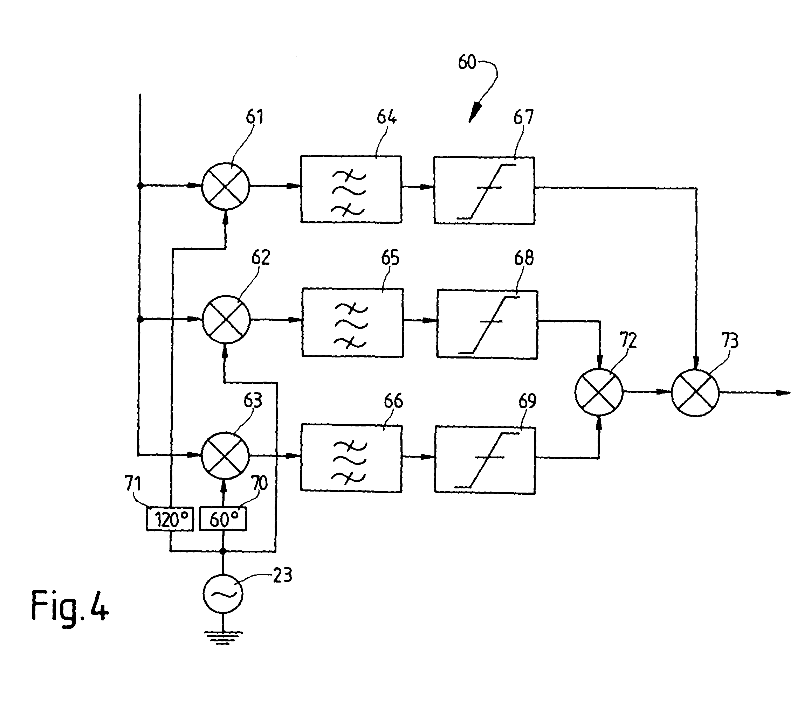

La figure 4 montre un autre mode de réalisation de l'étage hétérodyne dans lequel on engendre trois signaux déphasées de $\pi/3$ radians l'un par rapport à l'autre, signaux qui sont ensuite multipliés entre eux pour former le signal de message suréchantillonné. Un étage IF 60 comprend trois mélangeurs RF 61, 62 et 63, trois filtres passe-bande 64, 65 et 66, trois amplificateurs/limiteurs 67, 68 et 69, deux déphaseurs 70 et 71 et deux autres mélangeurs 72 et 73. L'étage RF, le démodulateur FM et les autres composants du récepteur FM ne sont pas représentés. Les déphaseurs 70 et 71 opèrent respectivement un déphasage du signal de l'oscillateur local 23 de 60° et de 120° de sorte que l'on obtient en combinaison avec le signal local d'oscillation, trois signaux, qui ont tous trois la fréquence de l'oscillateur local, mais qui sont déphasés de 60° l'un par rapport à l'autre. Ces trois signaux sont multipliés par le signal de l'étage RF par les mélangeurs 61, 62 et 63 de manière à produire à leurs sorties trois signaux IF ayant un décalage de phase de 60° l'un par rapport à l'autre.

Ces signaux passent à travers les filtres passe-bande 64, 65 et 66 et sont traités dans les amplificateurs/limiteurs 67, 68 et 69 pour ensuite être multipliés les uns par les autres en deux étapes. D'abord, les signaux apparaissant aux sorties respectives des limiteurs 68 et 69 sont multipliés dans le mélangeurs 72. Puis, le signal apparaissant à la sortie du limiteur 67 est multiplié par la sortie du mélangeur 72, dans le mélangeur 73. Ainsi, la sortie du mélangeur 73 fournit un signal dans lequel le signal de message est échantillonné à une fréquence triple de la fréquence intermédiaire f$_{IF}$. Toutefois, il est évident que les sorties des limiteurs 67, 68 et 69 peuvent être multipliés entre eux d'une façon et dans un ordre autres que ceux que l'on vient d'indiquer. A titre de variante, on peut utiliser par exemple un mélangeur à entrées multiples pour opérer d'un coup la multiplication des trois signaux IF.

Il est clair que dans un type donné de récepteur FM, l'on peut créer les signaux selon l'un ou l'autre des modes de réalisation représentés aux figures 2, 3 ou 4 ou encore selon une combinaison de ces trois modes de réalisation. L'un ou plusieurs de ces signaux peuvent également être créés par un circuit dans lequel on utilise deux ou plus de deux mélangeurs pour multiplier le signal local d'oscillation par le signal de l'étage RF, tandis que l'on ajoute des déphaseurs RF pour déphaser le signal de l'étage RF appliqué à l'un ou plusieurs de ces mélangeurs. A titre d'exemple, dans le cas d'un récepteur FM utilisant quatre signaux déphasés l'un par rapport à l'autre de $\pi/2$ radians, on peut prévoir trois déphaseurs pour déphaser le signal local d'oscillation respectivement de 45°, 90° et 135°. On peut également prévoir quatre mélangeurs à la suite de l'étage RF pour multiplier le signal provenant de cet étage RF par les trois signaux provenant des trois déphaseurs (ainsi que le signal de l'oscillateur local), pour engendrer les quatre signaux.

Selon une variante, on peut prévoir un seul mélangeur pour multiplier les signaux de l'étage RF par le signal local d'oscillation. Trois déphaseurs peuvent être prévus pour décaler le signal de sortie du mélangeur de 45°, 90° et 135°, les signaux apparaissant aux sorties de ces déphaseurs formant, avec le signal de sortie initial du mélangeur, les quatre signaux déphasés.

Dans une autre variante encore, on peut n'utiliser qu'un seul déphaseur pour décaler le signal d'oscillation local de 45°. Deux mélangeurs peuvent alors être prévus pour multiplier le signal de l'étage RF respectivement par le signal provenant du déphaseur et par le signal d'oscillation local initial. Dans ce ces, on peut prévoir deux déphaseurs supplémentaires pour décaler de 90° les sorties des mélangeurs de sorte que les signaux provenant des sorties de ces déphaseurs supplémentaires forment les quatre signaux, avec les signaux initiaux des deux mélangeurs.

Il est à noter que les diverses variantes décrites ci-dessus peuvent s'appliquer à des récepteurs FM à n signaux et que les mélangeurs et déphaseurs n'ont pas à être décrits ici pour que l'homme de métier puisse comprendre la flexibilité du concept de l'invention. Les figures 2 et 3 représentent des déphaseurs opérant des déphasages de $\pi/2$ radians et la figure 4 des déphaseurs qui provoquent des déphasages de $\pi/3$ et de $2\pi/3$ radians, mais d'autres variantes de circuit peuvent nécessiter des montages de déphasage qui opèrent des décalages sur des angles différents pour créer les n signaux permettant d'obtenir le suréchantillonnage du signal de message.

**Revendications**

1.  Récepteur radio destiné à recevoir un signal FM prédéterminé dans lequel un signal de message A (t) module la fréquence d'une porteuse, ce récepteur FM comprenant :

    -   un oscillateur local (23) destiné à engendrer un signal local d'oscillation,
    -   un étage hétérodyne (24) pour mélanger le signal FM prédéterminé avec le signal de l'oscillateur local de manière à abaisser la fréquence modulée par ledit signal de message jusqu'à une fréquence intermédiaire, et

- un étage démodulateur (33) destiné à recevoir le signal de sortie de l'étage hétérodyne et à extraire de celui-ci ledit signal de message,

caractérisé en ce que
ledit étage hétérodyne comprend :

- un générateur de signaux (25, 26, 27, 29, 30, 31, 32) pour engendrer n signaux $a_1$....$a_n$, dont chaque signal comprend ledit signal de message modulé à ladite fréquence intermédiaire, lesdits signaux $a_1$....$a_n$ ayant entre eux la relation

$$a_i = \cos \left[ \omega_{IF}t + k_f \int^t A(t)^*dt + \Omega + \pi^*(^i/_n) \right]$$

dans laquelle $\omega_{IF}$, $k_f$ et $\Omega$ sont des constantes, n est un entier positif supérieur ou égal à 2 et i peut avoir toute valeur des entiers positifs inférieurs ou égal à n, ledit étage hétérodyne comprenant en outre

- un multiplicateur (28) pour multiplier lesdits n signaux entre eux afin de produire un signal de sortie dudit étage hétérodyne dans lequel ledit signal de message est modulé à une fréquence égale à n fois ladite fréquence intermédiaire.

2. Récepteur radio suivant la revendication 1, caractérisé en ce que ledit générateur comprend au moins un déphaseur (27) destiné à décaler la phase dudit signal local d'oscillation de manière à produire un signal déphasé, et

- au moins deux mélangeurs (25, 26) qui sont destinés chacun à multiplier ledit signal FM prédéterminé par au moins un signal déphasé et par ledit signal d'oscillation local pour produire au moins l'un desdits n signaux.

3. Récepteur radio suivant l'une quelconque des revendications 1 et 2, caractérisé en ce que ledit générateur comprend en outre :

- au moins un déphaseur (54) destiné à décaler la phase de l'un des n signaux de manière à engendrer un autre desdits n signaux.

4. Récepteur radio suivant l'une quelconque des revendications précédentes, caractérisé en ce que ledit générateur comprend en outre :

- au moins un déphaseur RF destiné à décaler la phase dudit signal FM prédéterminé de manière à engendrer un signal FM prédéterminé déphasé, et

- au moins deux mélangeurs destinés chacun à multiplier ledit signal local d'oscillation par un signal FM prédéterminé et déphasé et par ledit signal FM prédéterminé de manière à produire au moins l'un desdits n signaux.

5. Récepteur radio suivant l'une quelconque des revendications précédentes, caractérisé en ce que ledit étage démodulateur (33) est accordé sur une fréquence égale à n fois ladite fréquence intermédiaire.

6. Récepteur radio suivant l'une quelconque des revendications précédentes, caractérisé en ce que ledit étage hétérodyne comprend en outre n limiteurs (31, 32) pour éliminer toute modulation d'amplitude desdits n signaux, avant qu'ils soient multipliés par ledit multiplicateur.

7. Récepteur radio suivant l'une quelconque des revendications précédentes, caractérisé en ce que ledit étage hétérodyne comprend en outre au moins un filtre (29, 30) à travers lequel est passé respectivement l'un desdits n signaux.

8. Récepteur radio suivant la revendication 6, caractérisé en ce que chacun desdits filtres est accordé sur ladite fréquence intermédiaire.

9. Récepteur radio suivant l'une quelconque des revendications précédentes, caractérisé en ce que ledit signal FM est un signal radio FM de diffusion.

**Patentansprüche**

1. Funkempfänger zum Empfang eines vorgegebenes FM-Signals, in dem ein Nachrichtensignal A(t) die Frequenz eines Trägers moduliert, wobei dieser FM-Empfänger enthält:

- einen Hilfsoszillator (23), der dazu vorgesehen ist, ein Hilfsoszillationssignal zu erzeugen,
- eine Überlagerungsstufe (24) zum Mischen des vorgegebenen FM-Signals mit dem Signal vom Hilfsoszillator, um die modulierte Frequenz durch das Nachrichtensignal auf eine Zwischenfrequenz abzusenken, und
- eine Demodulatorstufe (33) zum Empfang des Ausgangssignals der Überlagerungsstufe und zum Extrahieren des Nachrichtensignals aus diesem,

dadurch gekennzeichnet, daß
die Überlagerungsstufe enthält:

- einen Signalgenerator (25, 26, 27, 29, 30, 31, 32) zum Erzeugen von n Signalen $a_1...a_n$, wovon jedes das modulierte Nachrichtensignal mit der Zwischenfrequenz enthält, wobei die Signale $a_1...a_n$ untereinander die folgende Beziehung besitzen:

$$a_i = \cos[\omega_{IF}t + k_f \int_t A(t)dt + \Omega + \pi \frac{i}{n}]$$

in der $\omega_{IF}$, $k_F$ und $\Omega$ Konstanten sind, n eine positive ganze Zahl größer oder gleich 2 ist und i jeden positiven ganzzahligen Wert kleiner oder gleich n annehmen kann, wobei die Überlagerungsstufe außerdem enthält:
- einen Multiplizierer (28) zum Multiplizieren der n Signale miteinander, um ein Ausgangssignal der Überlagerungsstufe zu erzeugen, in dem das Nachrichtensignal mit einer Frequenz moduliert ist, die gleich der n-fachen Zwischenfrequenz ist.

2. Funkempfänger nach Anspruch 1, dadurch gekennzeichnet, daß der Generator wenigstens einen Phasenschieber (27) enthält, der dazu vorgesehen ist, die Phase des Hilfsoszillationssignals in der Weise zu verschieben, daß ein phasenverschobenes Signal erzeugt wird, und
- wenigstens zwei Mischer (25, 26), die dazu vorgesehen sind, jeweils das vorgegebene FM-Signal mit wenigstens einem phasenverschobenen Signal und mit dem Hilfsoszillationssignal zu multiplizieren, um wenigstens eines der n Signale zu erzeugen.

3. Funkempfänger nach einem der Ansprüche 1 und 2, dadurch gekennzeichnet, daß der Generator außerdem enthält:
- wenigstens einen Phasenschieber (54), der dazu vorgesehen ist, die Phase eines der n Signale in der Weise zu verschieben, daß ein anderes der n Signale erzeugt wird.

4. Funkempfänger nach einem der vorangehenden Ansprüche, dadurch gekennzeichnet, daß der Generator außerdem enthält:
- wenigstens einen HF-Phasenschieber, der dazu vorgesehen ist, die Phase des vorgegebenen FM-Signals in der Weise zu verschieben, daß ein phasenverschobenes vorgegebenes FM-Signal erzeugt wird, und
- wenigstens zwei Mischer, die jeweils dazu vorgesehen sind, das Hilfsoszillationssignal mit einem vorgegebenen und phasenverschobenen FM-Signal und mit dem vorgegebenen FM-Signal zu multiplizieren, um wenigstens eines der n Signale zu erzeugen.

5. Funkempfänger nach einem der vorangehenden Ansprüche, dadurch gekennzeichnet, daß die Demodulatorstufe (33) auf eine Frequenz abgestimmt ist, die gleich der n-fachen Zwischenfrequenz ist.

6. Funkempfänger nach einem der vorangehenden Ansprüche, dadurch gekennzeichnet, daß die Überlagerungsstufe außerdem n Begrenzer (31, 32) enthält, um aus den n Signalen jegliche Amplitudenmodulation zu beseitigen, bevor diese durch den Multiplizierer multipliziert werden.

7. Funkempfänger nach einem der vorangehenden Ansprüche, dadurch gekennzeichnet, daß die Überlagerungsstufe wenigstens ein Filter (29, 30) enthält, durch das jeweils eines der n Signale geschickt wird.

8. Funkempfänger nach Anspruch 6, dadurch gekennzeichnet daß jedes der Filter auf die Zwischenfrequenz abgestimmt ist.

9. Funkempfänger nach einem der vorangehenden Ansprüche, dadurch gekennzeichnet, daß das FM-Signal ein Rundfunk-FM-Signal ist.

**Claims**

1. Radio receiver for receiving a predetermined FM signal in which a message signal A(t) modulates the frequency of carrier signal, this receiver FM comprising :

   - a local oscillator (23) intended for producing a local oscillator signal,
   - a heterodyne stage (24) for mixing said predetermined FM signal with said local oscillator signal so as to reduce the frequency modulated by said message signal to an intermediate frequency, and
   - a demodulator stage (33) intended for receiving the output signal of said heterodyne stage and extracting said message signal therefrom,

   characterized in that said heterodyne stage comprises :

   - a signal generator (25, 26, 27, 29, 30, 31, 32) for producing n signals $a_1...a_n$ wherein each signal comprises said message signal modulated at said intermediate frequency, said signals $a_1...a_n$ being defined by the expression

$$a_i = \cos\left[\omega_{IF}t + k_f \int^t A(t)^*dt + \Omega + \pi^*\left(^i/_n\right)\right]$$

where $\omega_{IF}$, $k_f$ and $\Omega$ are constants, n is a positive integer greater than or equal to 2 and i is a positive integer lower than or equal to n, said heterodyne stage further comprising

- a multiplier (28) for multiplying said n signals together so as to produce an output signal of said heterodyne stage output signal wherein said message signal is modulated at a frequency equal to n times said intermediate frequency.

2. Radio receiver according to claim 1, characterized in that said signal generator includes at least one phase shifter (27) intended for shifting the phase of said local oscillator signal so as to produce a phase-shifted signal, and

- at least two mixers (25, 26) each intended for multiplying said predetermined FM signal by at least a phase-shifted signal and by said local oscillator signal so as to produce at least one of said n signals.

3. Radio receiver according to any one of claims 1 or 2, characterized in that said signal generator further includes :

- at least one phase shifter (54) intended for shifting the phase of one of said n signals so as to produce another one of said n signals.

4. Radio receiver according to any one of the preceding claims, characterized in that said signal generator further includes :

- at least one RF phase shifter intended for shifting the phase of said predetermined FM signal so as to produce a phase-shifted predetermined FM signal, and
- at least two mixers each intended for multiplying said local oscillator signal by a phase-shifted predetermined FM signal and by said predetermined FM signal so as to produce at least one of said n signals.

5. Radio receiver according to any one of the preceding claims, characterized in that said demodulator stage (33) is tuned to a frequency equal to n times said intermediate frequency.

6. Radio receiver according to any one of the preceding claims, characterized in that said heterodyne stage further comprises n limiters (31, 32) for removing any amplitude modulation of said n signals, before being multiplied by said multiplier.

7. Radio receiver according to any one of the preceding claims, characterized in that said heterodyne stage further comprises at least one filter (29, 30) through which one of said n signals is passed respectively.

8. Radio receiver according to claim 6, characterized in that each of said filters is tuned to said intermediate frequency.

9. Radio receiver according to any one of the preceding claims, characterized in that said FM signal is a broadcast FM radio signal.

Fig.1

$f_{IF}$

$f_{LO} = f_C + f_{IF}$

Fig.2

Fig.3

Fig.4

EP 0 624 959 B1